# EUROPÄISCHE PATENTANMELDUNG

(11) **EP 2 365 263 A2**
(43) Veröffentlichungstag der Anmeldung: **14.09.2011**
(21) Anmeldenummer: 11155541.3
(22) Anmeldetag: 23.02.2011
(51) Int. Cl.: F25D 17/02, H01L 31/052

(54) **Kühlvorrichtung und Verfahren zum Kühlen eines Betriebsmittels**

(30) Priorität: 12.03.2010 DE 102010011084
(71) Anmelder: Converteam GmbH, 12277 Berlin (DE)
(72) Erfinder: Meyer, Christian, 12305 Berlin (DE); Linzbach, Jonathan, 37079 Göttingen (DE); Backhaus, Christian, 14169 Berlin (DE)
(74) Vertreter: Dreiss

(57) **Zusammenfassung**

Es wird eine Kühlvorrichtung (10) zum Kühlen eines Betriebsmittels (22) mit Hilfe eines Kühlmittels sowie ein Verfahren zum Kühlen eines Betriebsmittels (22) beschrieben. Die Kühlvorrichtung (10) umfasst eine Wärmequelle zur Aufnahme von thermischer Energie aus dem Betriebsmittel in das Kühlmittel und eine Wärmesenke zur Abgabe von thermischer Energie aus dem Kühlmittel. Die Wärmequelle und die Wärmesenke (24) sind miteinander verbunden. Das Kühlmittel ist über einen Vorlauf (208) der Wärmequelle zuführbar und aus der Wärmesenke über einen Rücklauf (216) abführbar. Die Kühlvorrichtung umfasst eine Schaltvorrichtung (30) und zwei Tanks (12, 14) bzw. einen Schichtspeicher-Tank für Kühlmittel. Die Schaltvorrichtung (30) ist an die zwei Tanks (12, 14) bzw. den Schichtspeicher-Tank, den Vorlauf (208) und den Rücklauf (216) angeschlossen. Die Schalteinrichtung (30) ist derart ausgebildet, dass in einer Betriebsart "Mischkühlung" dem Vorlauf (208) das Kühlmittel aus beiden Tanks (12, 14) bzw. aus dem Schichtspeicher-Tank in einem vorgebbaren Mischverhältnis zuführbar ist.

## Beschreibung

Die Erfindung betrifft eine Kühlvorrichtung zum Kühlen eines Betriebsmittels nach dem Oberbegriff des Anspruchs 1 und ein Verfahren zum Kühlen eines Betriebsmittels nach dem Oberbegriff des Anspruchs 12.

Es ist bekannt, dass Betriebsmittel einer Vorrichtung gekühlt werden müssen, um deren ordnungsgemäße Funktion aufrechtzuerhalten oder um deren Funktion, wie beispielsweise den Wirkungsgrad, zu verbessern.

Aus der DE 20 2009 009 544 U1 ist eine Vorrichtung zur Steigerung des Wirkungsgrades einer Solaranlage bekannt. Zur Kühlung eines Fotovoltaikmoduls wird ein flüssiges Kühlmedium verwendet. Das Kühlmedium befindet sich in einem zentralen Sammelreservoir und/oder in einem Vorratsbehälter. Bei Bedarf wird das Kühlmedium auf der Bestrahlungsseite des Fotovoltaikmoduls offen vorbeigeführt.

Aus der DE 10 2008 003 724 A1 ist ein Verfahren zum Kühlen mehrerer wärmeerzeugender Komponenten bekannt, das einen primären und sekundären Kreislauf aufweist. Der sekundäre Kreislauf besteht aus einem Tank, einer Pumpe, Wärmequellen und einem Wärmetauscher. Mit dem primären Kreislauf wird das Kühlmedium des sekundären Kreislaufs gekühlt. Das Kühlmedium des sekundären Kreislaufs wird im Vorlauf zwischen dem Tank und den Wärmequellen durch den primären Kreislauf gekühlt. Bei den wärmeerzeugenden Komponenten handelt es sich beispielsweise um Motoren oder Umrichter.

Ausgehend von dem beschriebenen Stand der Technik liegt der vorliegenden Erfindung die Aufgabe zugrunde, die Kühlung des Betriebsmittels energie- und ressourceneffizient durchzuführen. Die Aufgabe wird durch eine Kühlvorrichtung nach dem Anspruch 1 und ein Verfahren nach dem Anspruch 12 gelöst.

Durch die erfindungsgemäße Kühlvorrichtung und das erfindungsgemäße Verfahren wird es ermöglicht, die Umgebungstemperatur als begrenzenden Faktor bei der Kühlung des Betriebsmittels auszuschließen. Die benötigte Energie der Kühlvorrichtung wird im Wesentlichen für den Betrieb einer Pumpe und eines Ventilators aufgewendet.

Durch den Einsatz von zwei Tanks zu einer Speicherung, Entnahme und Zuführung des Kühlmittels kann vorteilhaft Kühlmittel mit zwei unterschiedlichen Temperaturen in der Kühlvorrichtung vorgehalten werden. So kann beispielsweise Kühlmittel mit einer niedrigen Temperatur aus dem einen Tank entnommen, durch eine Wärmequelle erwärmt und dem anderen Tank zugeführt werden.

Des Weiteren ist eine Schalteinrichtung vorgesehen, die Kühlmittel aus beiden Tanks in einer Betriebsart "Mischkühlung" in einem vorgebbaren Mischverhältnis zusammenführen kann. Dadurch kann bei unterschiedlichen Temperaturen der Kühlmittel in den beiden Tanks durch die Schalteinrichtung das Kühlmittelgemisch bereitgestellt werden, das eine Vorlauftemperatur aufweist, die zwischen oder bei den Temperaturen der Kühlmittel aus den beiden Tanks liegt.

Vorteilhaft verbleibt das Kühlmittel während des Betriebs in der Kühlvorrichtung. Im Gegensatz zu einer Frischwasserkühlung besteht damit keine Abhängigkeit von verfügbaren Wasservorkommen. Außerdem beschränkt sich der Wasserverbrauch der erfindungsgemäßen Kühlvorrichtung, bei der Verwendung von Wasser als Kühlmittel oder als Teil des Kühlmittels, im Wesentlichen auf ein einmaliges Zuführen von Wasser.

Vorteilhaft wird auf den Einsatz einer Kältemaschine verzichtet, die sich durch einen hohen Energieaufwand auszeichnet.

Im Gegensatz zu einer Lösung, die nur einen einzigen Tank oder eine sequentielle Anordnung von Tanks zur Bevorratung von Kühlmittel vorsieht, muss vorteilhaft insgesamt weniger Kühlmittel vorgehalten werden. Dadurch ergeben sich geringere Kosten für die beiden Tanks sowie weiterhin vorteilhaft weniger Platzbedarf für die beiden Tanks.

In einer besonders vorteilhaften Weiterbildung der Kühlvorrichtung und des Verfahrens wird in der Betriebsart "Mischkühlung" Kühlmittel aus dem Rücklauf durch die Schalteinrichtung in einen der beiden Tanks zurückgeführt. Dadurch, dass das erwärmte Kühlmittel in nur einem Tank gesammelt wird, kann in dem anderen Tank das kühlere Kühlmittel vorgehalten werden.

In einer weiteren vorteilhaften Weiterbildung der Kühlvorrichtung und des Verfahrens wird in der Betriebsart "Regeneration" durch die Schalteinrichtung Kühlmittel aus dem einen Tank dem Vorlauf zugeführt. Dadurch kann vorteilhaft erreicht werden, dass das Kühlmittel, welches während der Betriebsart "Mischkühlung" erwärmt wurde, durch die Wärmesenke geführt und gekühlt wird.

In einer weiteren vorteilhaften Weiterbildung der Kühlvorrichtung und des Verfahrens wird in der Betriebsart "Regeneration" durch die Schalteinrichtung Kühlmittel aus dem Rücklauf dem anderen Tank zugeführt. Dadurch ist es vorteilhaft möglich, dass das Kühlmittel, welches durch die Wärmesenke gekühlt wird, in nur einem Tank zu sammeln.

In einer weiteren vorteilhaften Ausführungsform der Kühlvorrichtung und des Verfahrens wird in der Betriebsart "Kreislaufkühlung" durch die Schalteinrichtung der Rücklauf mit dem Vorlauf verbunden. Damit entsteht ein Kühlkreislauf, der vorteilhaft Wärmeenergie aus der Wärmequelle abführt und gespeichertes Kühlmittel in den Tanks nicht verwendet.

In einer weiteren vorteilhaften Weiterbildung der Kühlvorrichtung umfasst die Schalteinrichtung ein Proportionalventil. Das Proportionalventil vermischt das Kühlmittel aus dem einen Tank und das Kühlmittel aus dem anderen Tank in dem vorgebbaren Mischverhältnis zu dem Kühlmittelgemisch. Die Mischung zweier Kühlmittel mit unterschiedlicher Temperatur gestattet es, dass das entstehende Kühlmittelgemisch eine Temperatur aufweist, die zwischen den Temperaturen der zugeführten Kühlmittel liegt. Vorteilhaft muss dadurch nur soviel des kühleren Kühlmittels beigemischt werden, wie zum Erreichen einer bestimmten Temperatur notwendig ist.

In einer vorteilhaften Weiterbildung der Kühlvorrichtung ist der Wärmesenke ein Ventilator zugeordnet, der bevorzugt mit veränderlicher Drehzahl ausgeführt ist. Durch den Ventilator kann dem Kühlmittel die thermische Energie entzogen werden. Bei einer drehzahlgeregelten Ausführung kann dies bedarfsgesteuert geschehen.

In einer vorteilhaften Weiterbildung der Kühlvorrichtung ist der Kühlvorrichtung eine Pumpe zugeordnet, die bevorzugt mit veränderlicher Drehzahl ausgeführt ist. Durch die Pumpe wird das Kühlmittel zu einer Zirkulation bzw. Bewegung angeregt und läuft durch die Kühlvorrichtung. Bei einer drehzahlgeregelten Ausführung kann dies bedarfsgesteuert geschehen.

Eine vorteilhafte Weiterbildung des Verfahrens sieht vor, dass eine gemessene Vorlauftemperatur des Kühlmittelgemischs mit einem Sollwert verglichen wird. Durch den Vergleich der Vorlauftemperatur mit dem Sollwert kann eine Abweichung ermittelt werden. Auf Basis der Abweichung können Maßnahmen getroffen werden, die zu einer Übereinstimmung des Sollwerts und der gemessenen Vorlauftemperatur führen.

Eine entsprechende, vorteilhafte Weiterbildung des Verfahrens sieht vor, auf Basis des Vergleichs ein Signal zu bilden, das ein Proportionalventil entsprechend dem gewünschten Mischverhältnis stellt oder regelt.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.

In der Zeichnung zeigen
- Figur 1: eine Kühlvorrichtung zur Kühlung eines Umrichters;
- Figur 2: eine Schalteinrichtung der Kühlvorrichtung;
- Figur 3: die Kühlvorrichtung in einer Betriebsart "Kreislaufkühlung";
- Figur 4: die Kühlvorrichtung in einer Betriebsart "Mischkühlung";
- Figur 5: die Kühlvorrichtung in einer Betriebsart "Regeneration";
- Figur 6: einen Zustandsautomaten betreffend die Kühlvorrichtung;
- Figur 7: einen ersten Regelkreis betreffend die Betriebsart "Kreislaufkühlung";
- Figur 8: einen zweiten Regelkreis betreffend die Betriebsart "Mischkühlung"; und
- Figur 9: einen dritten Regelkreis betreffend die Betriebsart "Regeneration".

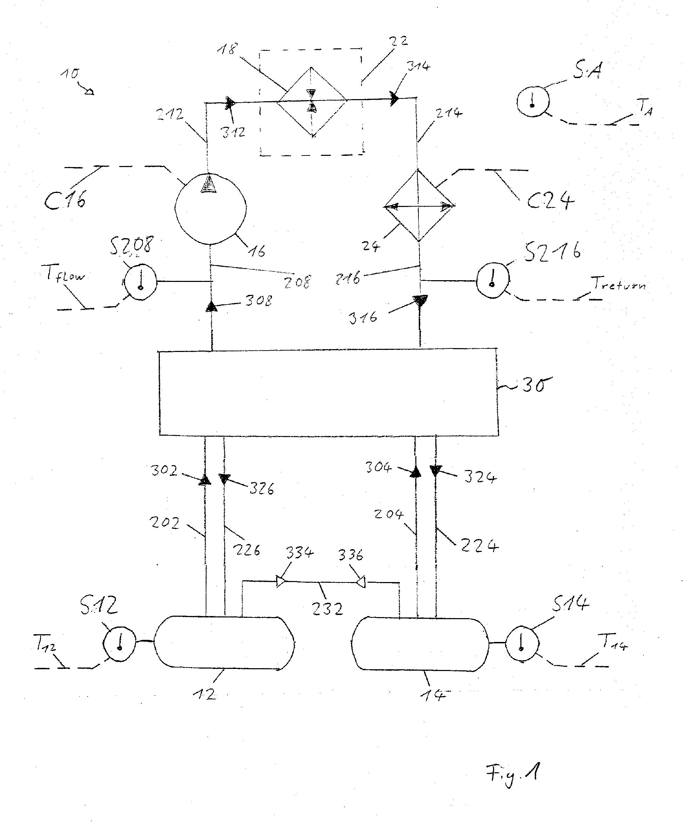

Figur 1 zeigt die Kühlvorrichtung 10, die zur Kühlung eines Umrichters 22 dient. Der Umrichter 22 wird allgemein als Betriebsmittel bezeichnet. Zur Kühlung des Umrichters 22 umfasst die Kühlvorrichtung 10 einen ersten Wärmetauscher 18. Der erste Wärmetauscher 18 wird allgemein auch als Wärmequelle bezeichnet. Der erste Wärmetauscher 18 ist dem Umrichter 22 zugeordnet und dient dazu, dem Umrichter 22 thermische Energie zu entziehen. Zu diesem Zweck strömt ein flüssiges Kühlmittel, das eine geringere Temperatur als der Umrichter 22 bzw. der erste Wärmetauscher 18 aufweist, durch den ersten Wärmetauscher 18 bzw. an dem ersten Wärmetauscher 18 vorbei, um durch Übertragung thermischer Energie von dem ersten Wärmetauscher 18 auf das Kühlmittel und den Abtransport des Kühlmittels den Umrichter 22 zu kühlen.

Der erste Wärmetauscher 18 ist über eine Leitung 212 mit einer Pumpe 16 verbunden. Die Pumpe 16 dient dazu, den ersten Wärmetauscher 18 mit dem Kühlmittel in einer Flussrichtung 312 zu versorgen. Die Pumpe 16 entnimmt das Kühlmittel einem Vorlauf 208 entsprechend einer Flussrichtung 308. Eine Vorlauftemperatur T_{flow} des Kühlmittels in dem Vorlauf 208 wird über einen an den Vorlauf 208 angebrachten Temperatursensor S208 ermittelt. Die Pumpe 16 ist mit einem Signal C16 beaufschlagt. Das Signal C16 dient dazu, die Förderleistung der Pumpe zu beeinflussen. Die Pumpe 16 kann ein- oder ausgeschaltet werden. Bei entsprechender Ausführung der Pumpe 16 kann über das Signal C16 die Pumpleistung der Pumpe 16 eingestellt werden.

Der erste Wärmetauscher 18 ist über eine Leitung 214 mit einem zweiten Wärmetauscher verbunden, dem ein Ventilator 24 zugeordnet ist. Der zweite Wärmetauscher wird allgemein als Wärmesenke bezeichnet. Die Leitung 214 dient dem Abfluss des Kühlmittels aus dem ersten Wärmetauscher 18 in einer Flussrichtung 314. Der Ventilator 24 dient dazu, dem zweiten Wärmetauscher thermische Energie zu entziehen und diese an die Umgebung abzugeben. Der Ventilator 24 ist drehzahlgeregelt ausgeführt. Der Ventilator 24 ist mit dem Signal C24 beaufschlagt, um die Kühlleistung des Ventilators 24 einzustellen. Der zweite Wärmetauscher gibt das Kühlmittel an einen Rücklauf 216 in eine Flussrichtung 316 ab. Eine Rücklauftemperatur Tᵣₑₜᵤᵣₙ des Kühlmittels in dem Rücklauf 216 wird mit einem an den Rücklauf 216 angebrachten Temperatursensor S216 ermittelt.

Eine Außentemperatur T_{A} wird mittels eines Temperatursensors SA ermittelt.

Der Vorlauf 208 und der Rücklauf 216 sind mit einer Schalteinrichtung 30 verbunden. Entsprechend der Flussrichtung 308 ist der Vorlauf 208 ein Ausgang der Schalteinrichtung 30. Entsprechend der Flussrichtung 316 ist der Rücklauf 216 ein Eingang der Schalteinrichtung 30. Leitungen 202, 204, 224 und 226 sind an die Schalteinrichtung 30 angeschlossen. Entsprechend einer Flussrichtung 302 ist die Leitung 202 ein Eingang der Schalteinrichtung 30. Entsprechend einer Flussrichtung 304 ist die Leitung 204 ein Eingang der Schalteinrichtung 30. Entsprechend einer Flussrichtung 324 ist die Leitung 224 ein Ausgang der Schalteinrichtung 30. Entsprechend einer Flussrichtung 326 ist die Leitung 226 ein Ausgang der Schalteinrichtung 30.

Die Leitungen 202 und 226 sind an einen Tank 12 angeschlossen. Entsprechend der Flussrichtung 302 ist die Leitung 202 ein Ausgang des Tanks 12, entsprechend der Flussrichtung 326 ist die Leitung 226 ein Eingang des Tanks 12. Die Leitungen 204 und 224 sind an einen Tank 14 angeschlossen. Entsprechend der Flussrichtung 304 ist die Leitung 204 ein Ausgang des Tanks 14. Entsprechend der Flussrichtung 324 ist die Leitung 224 ein Eingang des Tanks 14.

Die Tanks 12 und 14 dienen dazu, Kühlmittel über die Leitungen 226 bzw. 224 aufzunehmen, zu speichern und über die Leitungen 202 bzw. 204 abzugeben.

Die Tanks 12 und 14 sind über eine Luftleitung 232 verbunden. Die Luftleitung 232 ermöglicht entsprechend den Flussrichtungen 334 oder 336 einen Luft- und damit Druckaustausch zwischen den Tanks 12 und 14. Die Luftleitung 232 dient nicht zum Austausch von Kühlmittel zwischen den beiden Tanks 12 und 14.

An Stelle der beiden Tanks 12 und 14 ist es ebenso möglich einen Schichtspeicher-Tank zu verwenden. In diesem Fall werden sämtliche Funktionen der beiden Tanks 12, 14 von dem Schichtspeicher-Tank übernommen. In dem Schichtspeicher-Tank ist dabei das Kühlmittel in mehreren Bereichen übereinander geschichtet. In diesen Bereichen ist die Temperatur des Kühlmittels dann unterschiedlich. Es wird ausdrücklich darauf hingewiesen, dass die nachfolgende, anhand der beiden Tanks 12, 14 vorgenommene Beschreibung der Kühlvorrichtung 10 in entsprechender Weise auch mit Hilfe des Schichtspeicher-Tanks realisiert werden kann.

Eine Temperatur T₁₂ des Kühlmittels in dem Tank 12 wird durch einen Temperatursensor S12 ermittelt. Eine Temperatur T₁₄ des Kühlmittels in dem Tank 14 wird über einen Temperatursensor S14 ermittelt. Nicht gezeigte Füllstandssensoren messen einen jeweiligen Füllstand der beiden Tanks 12 und 14.

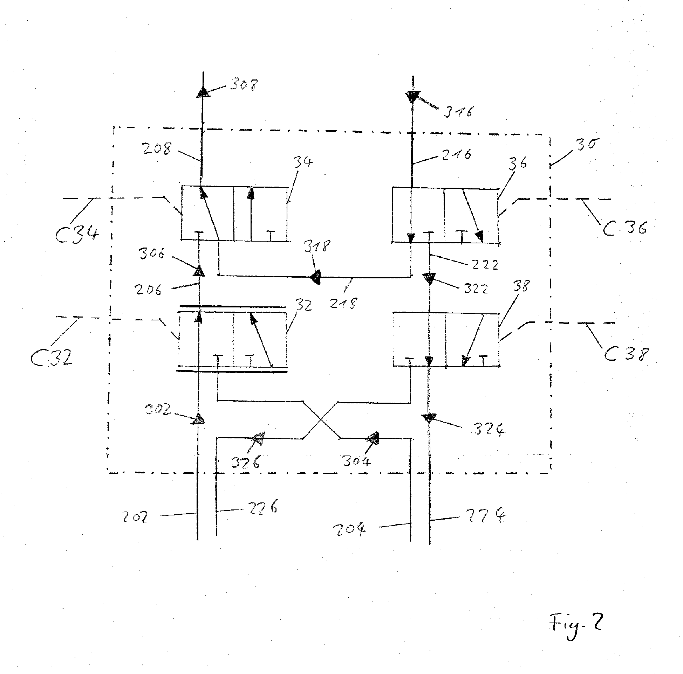

Figur 2 zeigt die Schalteinrichtung 30 mit den Leitungen 202, 204 und dem Rücklauf 216 als Eingänge der Schalteinrichtung 30 sowie dem Vorlauf 208 und den Leitungen 224 und 226 als Ausgänge der Schalteinrichtung 30.

Ein Proportionalventil 32 ist mit den Leitungen 202 und 204 sowie einer Leitung 206 verbunden. Entsprechend den Flussrichtungen 302 und 304 sind die Leitungen 202 und 204 Eingänge des Proportionalventils 32. Entsprechend einer Flussrichtung 306 ist die Leitung 206 ein Ausgang des Proportionalventils 32. Das Proportionalventil 32 ist mit einem Signal C32 beaufschlagt.

Die Funktionalität des Proportionalventils 32 umfasst eine erste und eine zweite Schaltstellung sowie mehrere Zwischenstellungen. In der ersten Schaltstellung verbindet das Proportionalventil 32 die Leitungen 202 und 206 und sperrt die Leitung 204, so dass das Kühlmittel nur von der Leitung 202 in die Leitung 206 fließt. In der zweiten Schaltstellung verbindet das Proportionalventil 32 die Leitungen 204 und 206 und sperrt die Leitung 202, so dass das Kühlmittel nur von der Leitung 204 in die Leitung 206 fließt. In einer der Zwischenstellungen des Proportionalventils 32 setzt sich das Kühlmittel in der Leitung 206 entsprechend einem vorgebbaren Mischverhältnis von Kühlmittel aus den Leitungen 202 und 204 zusammen und es entsteht ein Kühlmittelgemisch mit jeweiligen Anteilen der Kühlmittel aus den beiden Tanks 12 und 14. Besteht eine Temperaturdifferenz zwischen dem Kühlmittel in der Leitung 202 und dem Kühlmittel in der Leitung 204, so kann zum Einen durch die Wahl der ersten oder zweiten Schaltstellung des Proportionalventils 32 die Temperatur des Kühlmittels in der Leitung 206 auf den Wert der Temperatur des Kühlmittels in der Leitung 202 oder auf den Wert der Temperatur des Kühlmittels in der Leitung 204 bestimmt werden oder zum Anderen durch die Wahl einer Zwischenstellung des Proportionalventils 32 die Temperatur des Kühlmittels in der Leitung 206 auf einen Wert zwischen der Temperatur des Kühlmittels in der Leitung 202 und der Temperatur des Kühlmittels in der Leitung 204 eingestellt werden.

Ein Wegeventil 34 ist mit der Leitung 206, dem Vorlauf 208 sowie mit einer Leitung 218 verbunden. Entsprechend der Flussrichtung 306 und entsprechend einer Flussrichtung 318 sind die Leitungen 206 und 218 Eingänge des Wegeventils 34. Entsprechend der Flussrichtung 308 ist der Vorlauf 208 ein Ausgang des Wegeventils 34. Das Wegeventil 34 ist mit einem Signal C34 beaufschlagt.

Die Funktionalität des Wegeventils 34 umfasst eine erste und eine zweite Schaltstellung. Die erste Schaltstellung verbindet die Leitung 218 und den Vorlauf 208 und sperrt die Leitung 206, so dass das Kühlmittel von der Leitung 218 in den Vorlauf 208 fließt. Die zweite Schaltstellung verbindet die Leitung 206 und den Vorlauf 208 und sperrt die Leitung 218, so dass Kühlmittel von der Leitung 206 in den Vorlauf 208 fließt. Zwischenstellungen sind nicht vorgesehen.

Ein Wegeventil 36 ist mit dem Rücklauf 216 und der Leitung 218 sowie mit einer Leitung 222 verbunden. Entsprechend der Flussrichtung 316 ist der Rücklauf 216 ein Eingang des Wegeventils 36. Entsprechend der Flussrichtung 318 und einer Flussrichtung 322 sind die Leitungen 218 und 222 Ausgänge des Wegeventils 36. Das Wegeventil 36 ist mit einem Signal C36 beaufschlagt.

Die Funktionalität des Wegeventils 36 umfasst eine erste und eine zweite Schaltstellung. In der ersten Schaltstellung sind der Rücklauf 216 und die Leitung 218 verbunden und die Leitung 222 gesperrt, so dass das Kühlmittel von dem Rücklauf 216 in die Leitung 218 fließt. In der zweiten Schaltstellung sind der Rücklauf 216 und die Leitung 222 verbunden und die Leitung 218 gesperrt, so dass das Kühlmittel von dem Rücklauf 216 in die Leitung 222 fließt. Zwischenstellungen sind nicht vorgesehen.

Ein Wegeventil 38 ist mit den Leitungen 222, 224 und 226 verbunden. Entsprechend der Flussrichtung 322 ist die Leitung 222 ein Eingang des Wegeventils 38. Entsprechend den Flussrichtungen 324 und 326 sind die Leitungen 224 und 226 Ausgänge des Wegeventils 38. Das Wegeventil 38 ist mit einem Signal C38 beaufschlagt.

Die Funktionalität des Wegeventils 38 umfasst eine erste und eine zweite Schaltstellung. Die erste Schaltstellung verbindet die Leitungen 222 und 224 und sperrt die Leitung 226, so dass das Kühlmittel von der Leitung 222 in die Leitung 224 fließt. In der zweiten Schaltstellung sind die Leitungen 222 und 226 verbunden und die Leitung 224 gesperrt, so dass das Kühlmittel von der Leitung 222 in die Leitung 226 fließt. Zwischenstellungen sind nicht vorgesehen.

In einer Betriebsart "Kreislaufkühlung" der Kühlvorrichtung 10 befinden sich die Wegeventile 34 und 36 der Schalteinrichtung 30 in einer jeweiligen Schaltstellung, so dass die Leitungen 206 und 222 gesperrt sind und der Rücklauf 216 mit dem Vorlauf 208 verbunden ist. Die Schalteinrichtung 30 befindet sich damit in einem Zustand, in dem das Kühlmittel von dem Rücklauf 216 in den Vorlauf 208 fließt.

In einer Betriebsart "Mischkühlung" der Kühlvorrichtung 10 befinden sich die Wegeventile 34, 36 und 38 sowie das Proportionalventil 32 der Schalteinrichtung 30 in einer jeweiligen Schalt- bzw. Zwischenstellung, so dass die Leitung 226 gesperrt ist, der Rücklauf 216 mit der Leitung 224 verbunden ist sowie die Leitung 202 und die Leitung 204 mit dem Vorlauf 208 verbunden sind. Damit befindet sich die Schalteinrichtung 30 in einem Zustand, in dem das Kühlmittel von dem Rücklauf 216 in die Leitung 224 fließt und das Kühlmittel entweder aus einer der Leitungen 202 bzw. 204 oder in dem vorgebbaren Mischverhältnis von Kühlmittel aus den Leitungen 202 und 204 in den Vorlauf 208 fließt.

In einer Betriebsart "Regeneration" der Kühlvorrichtung 10 befinden sich die Wegeventile 34, 36, 38 sowie das Proportionalventil 32 der Schalteinrichtung 30 in einer jeweiligen Schalt- bzw. Zwischenstellung, so dass die Leitungen 202 und 224 gesperrt sind, die Leitung 204 mit dem Vorlauf 208 verbunden ist und der Rücklauf 216 mit der Leitung 226 verbunden ist. Die Schalteinrichtung 30 befindet sich damit in einem Zustand, in dem das Kühlmittel aus der Leitung 204 in den Vorlauf 208 fließt und das Kühlmittel aus dem Rücklauf 216 in die Leitung 226 fließt.

Aufgrund einer hohen Wärmekapazität kommt als Kühlmittel beispielsweise ein Glykol/Wasser-Gemisch zum Einsatz. Das Glykol/Wasser-Gemisch setzt sich beispielsweise zu 20% aus Glykol und zu 80% aus Wasser zusammen.

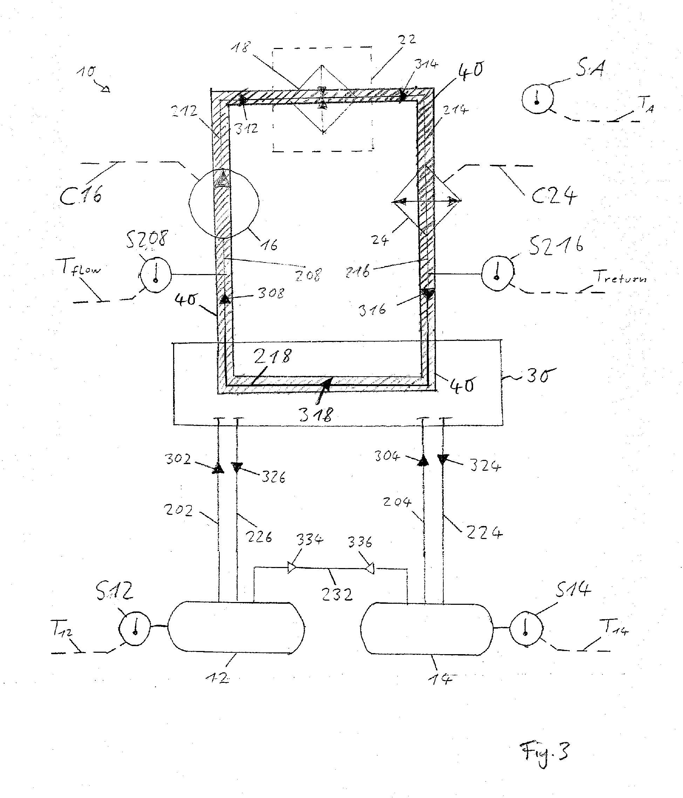

Figur 3 zeigt die Kühlvorrichtung 10 in der Betriebsart "Kreislaufkühlung". Entsprechend der Markierung 40 fließt das Kühlmittel in einem Kreislauf. Die Pumpe 16 fördert das Kühlmittel aus dem Vorlauf 208 in die Leitung 212 zu dem ersten Wärmetauscher 18. In dem ersten Wärmetauscher 18 nimmt das Kühlmittel thermische Energie auf, um nach einer Weiterleitung über die Leitung 214 thermische Energie mittels des zweiten Wärmetauschers und des Ventilators 24 abzugeben. Von dem Ventilator 24 aus gelangt das Kühlmittel über den Rücklauf 216 zu der Schalteinrichtung 30. In der Betriebsart "Kreislaufkühlung" leitet die Schalteinrichtung 30 das Kühlmittel aus dem Rücklauf 216 über die Leitung 218 gemäß der Flussrichtung 318 an den Vorlauf 208 weiter. Das Kühlmittel in den Tanks 12 und 14 wird in der Betriebsart "Kreislaufkühlung" nicht verwendet.

Die Betriebsart "Kreislaufkühlung" ist bei einer normalen Außentemperatur T_{A} unter beispielsweise 40°C aktiv. Bei normalen Außentemperaturen T_{A} genügt die Kühlung durch den Ventilator 24, um einen zur Kühlung des Umrichters 22 nötigen ersten Sollwert der Vorlauftemperatur T_{flow} von 43 °C zu erreichen. Dies bedeutet, dass eine normale Nachfrage nach Kühlleistung zur Kühlung des Umrichters 22 besteht.

Wird der Umrichter 22 beispielsweise einer Photovoltaikanlage gekühlt, so ist die Betriebsart "Kreislaufkühlung" vorzugsweise in der ersten Tageshälfte aktiv, in der Sonneneinstrahlung vorhanden, aber die Außentemperatur T_{A} noch niedrig genug ist, um den Umrichter 22 genügend zu kühlen.

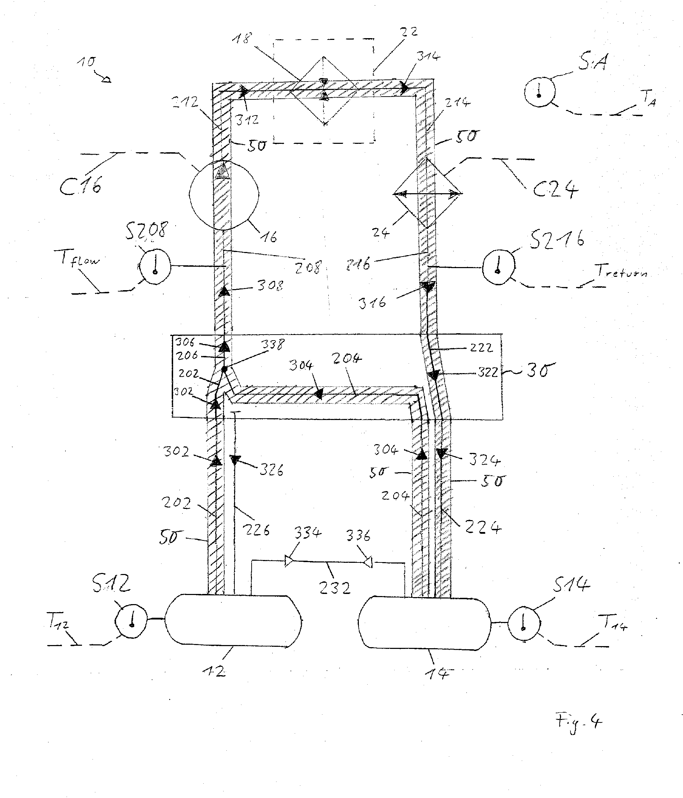

Figur 4 zeigt die Kühlvorrichtung 10 in der Betriebsart "Mischkühlung". Das Kühlmittel wird entsprechend der Markierung 50 durch die Kühlvorrichtung 10 geführt. Das Kühlmittel aus den Tanks 12 und 14 wird über die Leitungen 202 und 204 der Schalteinrichtung 30 zugeführt. In der Schalteinrichtung 30 wird das Kühlmittel aus der Leitung 202 und das Kühlmittel aus der Leitung 204 an einem Knoten 338 zusammengeführt. Der Knoten 338 entspricht dem Proportionalventil 32 aus der Figur 2. Das Kühlmittel mit der Temperatur T₁₂ aus dem Tank 12 und das Kühlmittel mit der Temperatur T₁₄ aus dem Tank 14 wird in einem vorgebbaren Mischverhältnis an dem Knoten 338 zu einem Kühlmittelgemisch zusammengeführt. Nach einem Durchlaufen der Leitung 206 wird in dem Vorlauf 208 die Vorlauftemperatur T_{flow} ermittelt. Die Pumpe 16 fördert das Kühlmittel aus dem Vorlauf 208 in die Leitung 212 zu dem ersten Wärmetauscher 18. Der erste Wärmetauscher 18 führt dem Kühlmittel thermische Energie zu und leitet das Kühlmittel über die Leitung 214 an den Ventilator 24 weiter. Der Ventilator 24 entzieht dem Kühlmittel thermische Energie und leitet das Kühlmittel über den Rücklauf 216 an die Schalteinrichtung 30 weiter. Die Schalteinrichtung 30 verbindet den Rücklauf 216 über die Leitung 222 mit der Leitung 224 und leitet damit das Kühlmittel dem Tank 14 zu.

In der Betriebsart "Mischkühlung" werden die Kühlmittel aus den Tanks 12 und 14 mit den jeweiligen Temperaturen T₁₂ und T₁₄ in der Schalteinrichtung 30 in dem vorgebbaren Mischverhältnis derart vermischt, dass sich ein zweiter Sollwert der Vorlauftemperatur T_{flow} von 43 °C ergibt. Vor Eintritt in die Betriebsart "Mischkühlung" befindet sich in dem Tank 14 idealerweise möglichst wenig Kühlmittel und in dem Tank 12 idealerweise der Großteil des vorhandenen Kühlmittels. Des Weiteren ist die Temperatur T₁₂ des Kühlmittels in dem Tank 12 geringer als der zweite Sollwert der Vorlauftemperatur T_{flow}.

Üblicherweise kommt die Betriebsart "Mischkühlung" zum Einsatz, wenn die beispielsweise in der Betriebsart "Kreislaufkühlung" durchgeführte Rückkühlung durch den Ventilator 24 nicht mehr ausreicht, um den ersten Sollwert der Vorlauftemperatur T_{flow} zu erreichen. Das bedeutet, dass bei einer hohen Umgebungstemperatur T_{A} von beispielsweise über 40°C eine hohe Nachfrage nach Kühlleistung zur Kühlung des Umrichters 22 besteht.

In der Betriebsart "Mischkühlung" ist üblicherweise trotz der durch den Ventilator 24 abgeführten thermischen Energie die Nachlauftemperatur Tᵣₑₜᵤᵣₙ größer als die Vorlauftemperatur T_{flow}. Damit keine Luft in die Leitungen der Kühlvorrichtung 10 gelangt, werden die beiden Tanks 12 und 14 üblicherweise so betrieben, dass sie nie ganz leer sind.

Befindet sich genügend förderbares Kühlmittel in den beiden Tanks 12 und 14, so wird das an dem Knoten 338 befindliche Proportionalventil 32 aus Figur 2 so eingestellt, dass die Vorlauftemperatur T_{flow} des Kühlmittels in dem Vorlauf 208 dem zweiten Sollwert der Vorlauftemperatur T_{flow} entspricht.

Die Betriebsart "Mischkühlung" kann solange fortgesetzt werden, wie der zweite Sollwert der Vorlauftemperatur T_{flow} eingehalten werden kann bzw. solange Kühlmittel mit der benötigten Temperatur T₁₂ in dem Tank 12 vorhanden ist.

Entsprechend der Betriebsart "Mischkühlung" ergibt sich eine weitere Eigenschaft der beiden Tanks 12 und 14. Beide Tanks 12 und 14 müssen jeweils das gleiche Volumen fassen. Ist einer der Tanks 12 oder 14 leer, so muss der jeweils andere Tank 14 oder 12 das gesamte Volumen des Kühlmittels exklusive des in den Leitungen bzw. anderen Teilen der Kühlvorrichtung 10 vorhandenen Kühlmittels fassen.

Sobald der Ventilator 24 in der Betriebsart "Kreislaufkühlung" bei einer hohen Außentemperatur T_{A} von beispielsweise über 40°C das Kühlmittel nicht mehr derart zurückkühlen kann, dass eine notwendige Kühlung des Umrichters 22 gewährleistet ist, wird die Betriebsart "Mischkühlung" aktiviert. Besonders während der Nachmittagsstunden kann eine hohe Nachfrage nach Kühlleistung auftreten. Es wird dann das Kühlmittelgemisch bereitgestellt, welches nur zu dem Anteil aus dem kühleren Kühlmittel besteht, der notwendig ist, um den zweiten Sollwert der Vorlauftemperatur T_{flow} zu erreichen.

Beispielsweise bei einer Photovoltaikanlage ist die Betriebsart "Mischkühlung" vor allem in der zweiten Tageshälfte aktiv. Vor allem der Einsatz an Orten, die zeitweise eine Außentemperatur T_{A} größer als die benötigte Vorlauftemperatur T_{flow} aufweisen, verlangt die Bereitstellung des entsprechend gekühlten Kühlmittels bzw.
Kühlmittelgemischs.

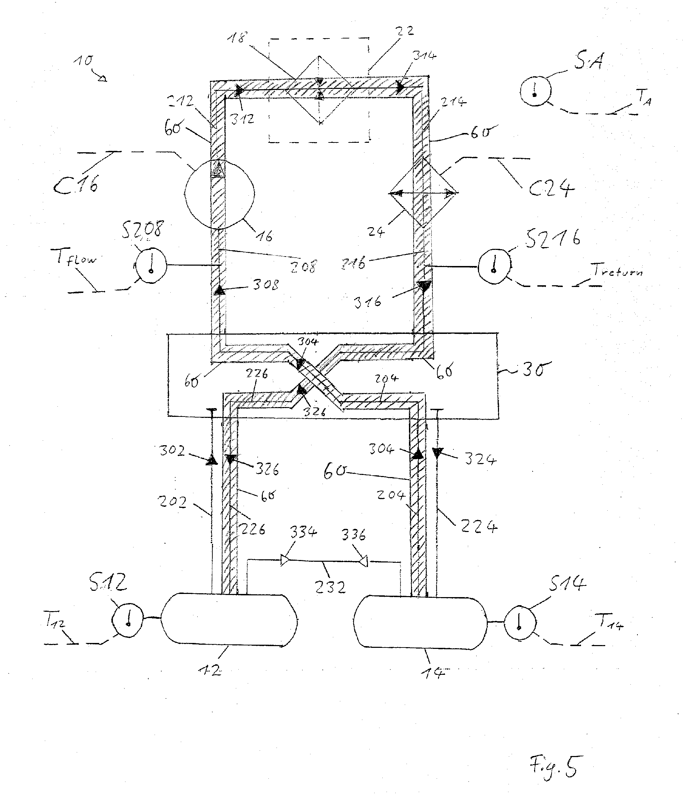

Figur 5 zeigt die Kühlvorrichtung 10 in einem Zustand "Regeneration". Das Kühlmittel wird entsprechend der Markierung 60 durch die Kühlvorrichtung 10 geführt. Hierzu befindet sich die Schalteinrichtung 30 in einem Zustand, in dem das Kühlmittel aus dem Tank 14 über die Leitung 204 und über die Leitung 206 aus der Figur 2 in den Vorlauf 208 geführt wird. Des Weiteren wird Kühlmittel aus dem Rücklauf 216 über die Leitung 222 aus Figur 2 der Leitung 226 zugeführt. Die Betriebsart "Regeneration" dient dazu, Kühlmittel aus dem Tank 14 mit der Temperatur T₁₄ so durch die Kühlvorrichtung 10 zu fördern, dass sich im Tank 12 Kühlmittel mit der Temperatur T₁₂ kleiner der Temperatur T₁₄ sammelt. Idealerweise wird die Temperatur T₁₂ gleich der Außentemperatur T_{A}.

Hierzu ist üblicherweise der Umrichter 22 und damit auch der erste Wärmetauscher 18 nicht in Betrieb. Damit wird das Kühlmittel, das durch den ersten Wärmetauscher 18 läuft, im Wesentlichen nicht erwärmt. Die Kühlung des Kühlmittels durch den Ventilator 24 wird entsprechend einem zu erreichenden Sollwert der Rücklauftemperatur Tᵣₑₜᵤᵣₙ durchgeführt. Die Wahl des Sollwerts der Rücklauftemperatur Tᵣₑₜᵤᵣₙ ist ortsabhängig und wird abhängig von den ortsüblichen Nachttemperaturen gewählt. Beispielsweise in Spanien kann ein Bereich von 20 °C bis 25 °C für den Sollwert der Rücklauftemperatur Tᵣₑₜᵤᵣₙ vorgebbar sein, wohingegen beispielsweise in Dubai ein höherer Bereich von 30°C bis 35°C für den Sollwert der Rücklauftemperatur Tᵣₑₜᵤᵣₙ erforderlich sein kann.

Die Betriebsart "Regeneration" wird solange durchgeführt, bis sämtliches aus Tank 14 förderbare Kühlmittel in den Tank 12 überführt wurde bzw. solange eine Rückkühlung des Kühlmittels möglich ist. Eine Rückkühlung des Kühlmittels ist beispielsweise nur möglich, solange die Außentemperatur T_{A} unter einem bestimmten Wert bleibt.

Zum Beispiel eine Photovoltaikanlage wird nachts üblicherweise aufgrund der fehlenden Sonneneinstrahlung nicht betrieben, weshalb das Kühlmittel in der Kühlvorrichtung 10 nicht durch den Umrichter 22 bzw. den ersten Wärmetauscher 18 erwärmt wird. Somit kann nachts das tagsüber in der Betriebsart "Mischkühlung" erwärmte Kühlmittel durch die Kühlvorrichtung 10 geführt werden. Dabei wird es von dem Ventilator 24 idealerweise auf die Außentemperatur T_{A} herabgekühlt und in dem Tank 12 gesammelt. Die Außentemperatur T_{A} beträgt beispielsweise 25°C. In dem Tank 12 steht das Kühlmittel dann für die nächste Durchführung der Betriebsart "Mischkühlung" bereit.

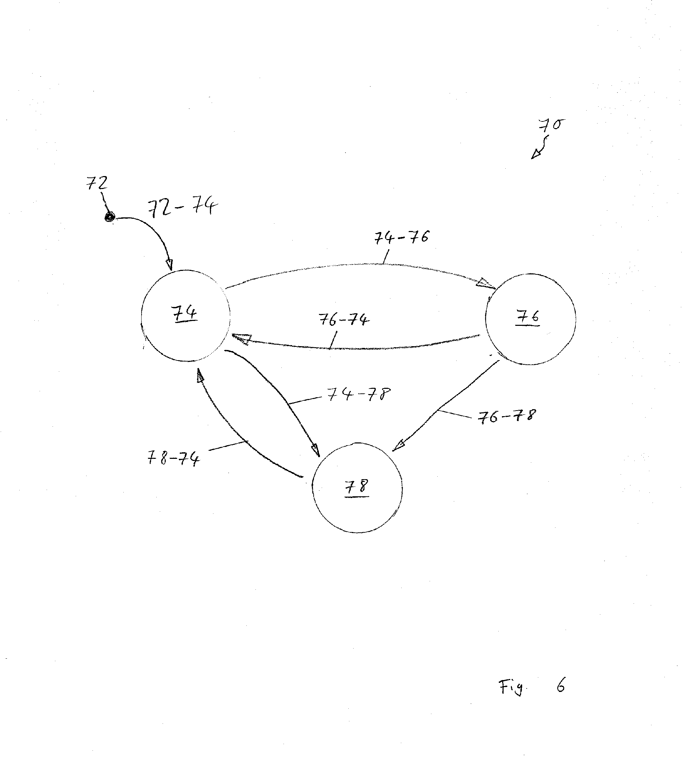

Figur 6 zeigt einen Zustandsautomaten 70 für den Betrieb der Kühlvorrichtung 10. Der Zustandsautomat 70 umfasst einen Startzustand 72, einen Zustand 74 entsprechend der Betriebsart "Kreislaufkühlung" der Kühlvorrichtung 10 in Figur 3, einen Zustand 76 entsprechend der Betriebsart "Mischkühlung" der Kühlvorrichtung 10 in Figur 4 und einen Zustand 78 entsprechend der Betriebsart "Regeneration" der Kühlvorrichtung 10 in Figur 5. Ein Zustand, der den Leerlauf der Kühlvorrichtung 10, also eine nicht stattfindende Zirkulation des Kühlmittels berücksichtigt, ist nicht dargestellt.

Eine Transition 72-74 überführt den Zustandsautomaten von dem Startzustand 72 in den Zustand 74. Diese Transition 72-74 wird nach dem Starten des Zustandsautomaten 70 durchgeführt.

Durch die Ausführung einer Transition 74-76 wird der Zustandsautomat 70 von dem Zustand 74 in den Zustand 76 überführt. Die Transition 74-76 wird ausgeführt, wenn die Außentemperatur T_{A} in Figur 1 einen Wert von beispielsweise 40°C überschreitet und der Umrichter 22 betrieben wird. Damit wird von der Betriebsart "Kreislaufkühlung" in die Betriebsart "Mischkühlung" gewechselt.

Durch die Ausführung einer Transition 76-74 wird der Zustandsautomat 70 von dem Zustand 76 in den Zustand 74 überführt. Die Transition 76-74 wird ausgeführt, wenn die Außentemperatur T_{A} in Figur 1 unter einen Wert von beispielsweise 40°C fällt und der Umrichter 22 betrieben wird. Damit wird von der Betriebsart "Mischkühlung" in die Betriebsart "Kreislaufkühlung" gewechselt.

Durch die Ausführung einer Transition 76-78 wird der Zustandsautomat 70 von dem Zustand 76 in den Zustand 78 überführt. Die Transition 76-78 wird ausgeführt, wenn die Außentemperatur T_{A} unter einen Wert von beispielsweise 25°C fällt und der Umrichter 22 nicht betrieben wird. Damit wird von der Betriebsart "Mischkühlung" in die Betriebsart "Regeneration" gewechselt.

Durch die Ausführung einer Transition 74-78 wird der Zustandsautomat 70 von dem Zustand 74 in den Zustand 78 überführt. Die Transition 74-78 wird ausgeführt, wenn die Außentemperatur T_{A} unter einen Wert von beispielsweise 25°C fällt und der Umrichter 22 nicht betrieben wird. Damit wird von der Betriebsart "Kreislaufkühlung" in die Betriebsart "Regeneration" gewechselt.

Durch die Ausführung einer Transition 78-74 wird der Zustandsautomat 70 von dem Zustand 78 in den Zustand 74 überführt. Die Transition 78-74 wird ausgeführt, wenn der Umrichter 22 betrieben wird. Damit wird von der Betriebsart "Regeneration" in die Betriebsart "Kreislaufkühlung" gewechselt.

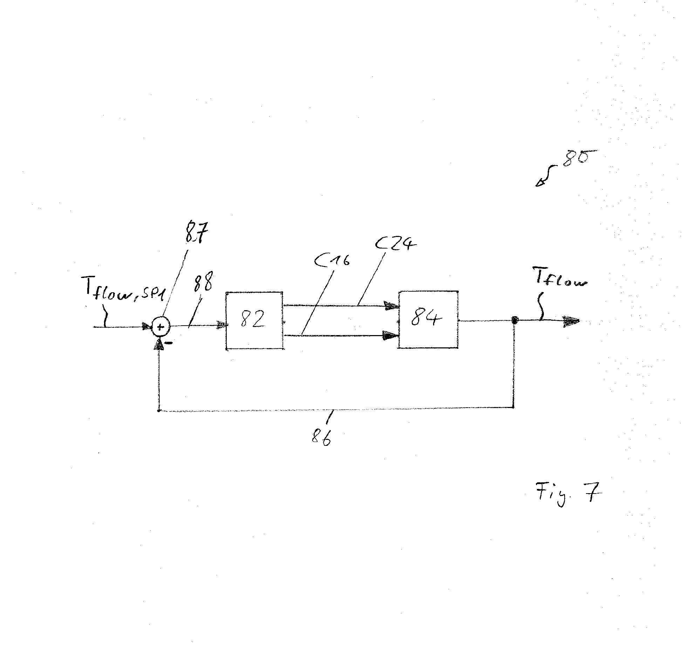

Figur 7 zeigt einen ersten Regelkreis 80 für die Betriebsart "Kreislaufkühlung". Die Vorlauftemperatur T_{flow} ist die Regelgröße des ersten Regelkreises 80. Die Vorlauftemperatur T_{flow} wird aus einer Regelstrecke 84 ermittelt, über die Rückführung 86 einer Stelle 87 zugeführt und von dem ersten Sollwert T_{flow}, _{SP1} der Vorlauftemperatur T_{flow} subtrahiert. Die Subtraktion an der Stelle 87 ergibt eine Regelabweichung 88, die einem Regler 82 zugeführt wird. Der Regler 82 ermittelt die Signale C16 und C24, die als Stellgrößen der Regelstrecke 84 zugeführt werden. Das Signal C16 beeinflusst die Förderleistung der Pumpe 16 und damit eine Strömungsgeschwindigkeit des Kühlmittels. Das Signal C24 beeinflusst die Drehzahl des Ventilators 24 und damit die Abfuhr von thermischer Energie aus dem Kühlmittel. Der Regler 82 ist derart hergerichtet, dass er die Signale C16 und C24 derart beeinflusst, so dass die ermittelte Vorlauftemperatur T_{flow} als Regelgröße im Zeitverlauf gegen den ersten Sollwert T_{flow}, _{SP1} der Vorlauftemperatur T_{flow} strebt.

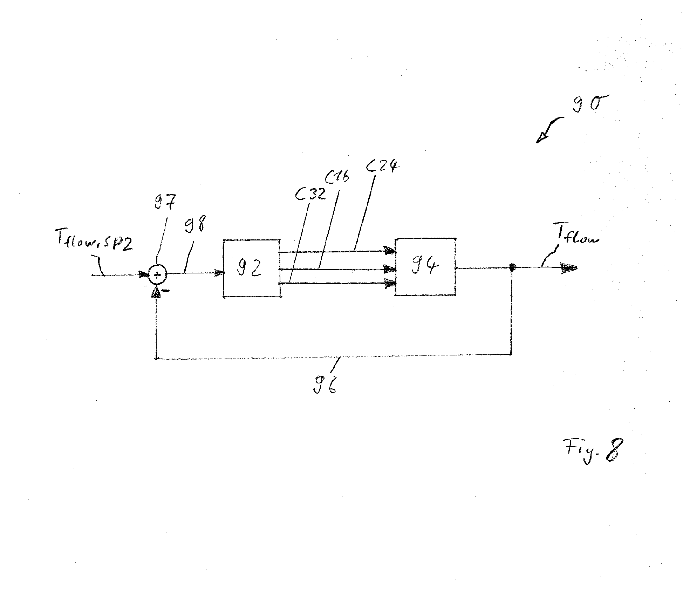

Figur 8 zeigt einen zweiten Regelkreis 90 für die Betriebsart "Mischkühlung". Die Vorlauftemperatur T_{flow} ist die Regelgröße des zweiten Regelkreises 90. Die Vorlauftemperatur T_{flow} wird aus einer Regelstrecke 94 ermittelt, über die Rückführung 96 einer Stelle 97 zugeführt und von dem zweiten Sollwert T_{flow}, _{SP2} der Vorlauftemperatur T_{flow} subtrahiert. Die Subtraktion an der Stelle 97 ergibt eine Regelabweichung 98, die einem Regler 92 zugeführt wird. Der Regler 92 ermittelt die Signale C16, C24 und C32, die als Stellgrößen der Regelstrecke 94 zugeführt werden. Das Signal C16 beeinflusst die Förderleistung der Pumpe 16 und damit die Strömungsgeschwindigkeit des Kühlmittels. Das Signal C24 beeinflusst die Drehzahl des Ventilators 24 und damit die Abfuhr von thermischer Energie aus dem Kühlmittel. Das Signal C32 beeinflusst die Stellung des Proportionalventils 32 und damit die Zusammensetzung des Kühlmittelgemischs aus den Kühlmitteln aus den beiden Tanks 12 und 14. Der Regler 92 ist derart hergerichtet, dass er die Signale C16, C24 und C32 derart beeinflusst, so dass die ermittelte Vorlauftemperatur T_{flow} als Regelgröße im Zeitverlauf gegen den zweiten Sollwert T_{flow}, _{SP2} der Vorlauftemperatur T_{flow} strebt.

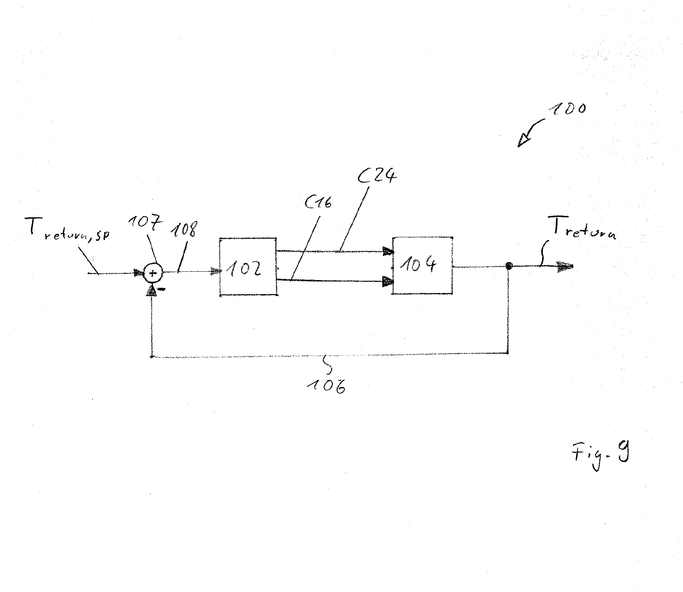

Figur 9 zeigt einen dritten Regelkreis 100 für die Betriebsart "Regeneration". Die Rücklauftemperatur Tᵣₑₜᵤᵣₙ ist die Regelgröße des dritten Regelkreises 100. Die Rücklauftemperatur Tᵣₑₜᵤᵣₙ wird aus einer Regelstrecke 104 ermittelt, über die Rückführung 106 einer Stelle 107 zugeführt und von dem Sollwert Tᵣₑₜᵤᵣₙ, _{SP} der Rücklauftemperatur Tᵣₑₜᵤᵣₙ subtrahiert. Die Subtraktion an der Stelle 107 ergibt eine Regelabweichung 108, die einem Regler 102 zugeführt wird. Der Regler 102 ermittelt die Signale C16 und C24, die als Stellgrößen der Regelstrecke 104 zugeführt werden. Das Signal C16 beeinflusst die Förderleistung der Pumpe 16 und damit die Strömungsgeschwindigkeit des Kühlmittels. Das Signal C24 beeinflusst die Drehzahl des Ventilators 24 und damit die Abfuhr von thermischer Energie aus dem Kühlmittel. Der Regler 102 ist derart hergerichtet, dass er die Signale C16 und C24 derart beeinflusst, so dass die ermittelte Rücklauftemperatur Tᵣₑₜᵤᵣₙ als Regelgröße im Zeitverlauf gegen den Sollwert Tᵣₑₜᵤᵣₙ, _{SP} der Rücklauftemperatur Tᵣₑₜᵤᵣₙ strebt.

Die Kühlvorrichtung 10 und das Verfahren zur Kühlung eines Betriebsmittels sind auch auf andere Anlagen und Betriebsmittel als die erläuterten anwendbar. Speziell Betriebsmittel, die eine temporäre, hohe Nachfrage nach Kühlleistung und Möglichkeiten zu einer Rückkühlung bzw. Regeneration des Kühlmittels aufweisen, eignen sich zur Kühlung des Betriebsmittels durch die Kühlvorrichtung 10.

## Patentansprüche

1. Kühlvorrichtung (10) zum Kühlen eines Betriebsmittels mit Hilfe eines Kühlmittels,
- umfassend eine Wärmequelle zur Aufnahme von thermischer Energie aus dem Betriebsmittel in das Kühlmittel und eine Wärmesenke zur Abgabe von thermischer Energie aus dem Kühlmittel,
- wobei die Wärmequelle und die Wärmesenke miteinander verbunden sind,
- und wobei das Kühlmittel der Wärmequelle über einen Vorlauf (208) zuführbar ist und aus der Wärmesenke über einen Rücklauf (216) abführbar ist,
**dadurch gekennzeichnet,**
- **dass** die Kühlvorrichtung (10) eine Schalteinrichtung (30) und zwei Tanks (12, 14) bzw. einen Schichtspeicher-Tank für Kühlmittel umfasst,
- **dass** die Schalteinrichtung (30) an die beiden Tanks (12, 14) bzw. den Schichtspeicher-Tank, den Vorlauf (208) und den Rücklauf (216) angeschlossen ist,
- und **dass** die Schalteinrichtung (30) derart ausgebildet ist, dass in einer Betriebsart "Mischkühlung" dem Vorlauf (208) das Kühlmittel aus den beiden Tanks (12, 14) bzw. aus dem Schichtspeicher-Tank in einem vorgebbaren Mischverhältnis zuführbar ist.

2. Kühlvorrichtung (10) nach dem Anspruch 1, wobei die Schalteinrichtung (30) derart ausgebildet ist, dass in der Betriebsart "Mischkühlung" das Kühlmittel aus dem Rücklauf (216) in einen der beiden Tanks (14) bzw. in den Schichtspeicher-Tank abführbar ist.

3. Kühlvorrichtung (10) nach einem der vorstehenden Ansprüche, wobei die Schalteinrichtung (30) derart ausgebildet ist, dass in einer Betriebsart "Regeneration" das Kühlmittel aus einem der beiden Tanks (14) bzw. aus dem Schichtspeicher-Tank dem Vorlauf (208) zuführbar ist.

4. Kühlvorrichtung (10) nach Anspruch 3, wobei die Schalteinrichtung (30) derart ausgebildet ist, dass in der Betriebsart "Regeneration" das Kühlmittel aus dem Rücklauf (216) dem anderen Tank (12) bzw. aus dem Schichtspeicher-Tank zuführbar ist.

5. Kühlvorrichtung nach einem der vorstehenden Ansprüche, wobei die die Schalteinrichtung (30) derart ausgebildet ist, dass in einer Betriebsart "Kreislaufkühlung" der Rücklauf (216) mit dem Vorlauf (208) verbunden ist.

6. Kühlvorrichtung (10) nach einem der vorstehenden Ansprüche, wobei die Schalteinrichtung (30) ein Proportionalventil (32) umfasst, das dazu ausgebildet ist, das Kühlmittel aus den beiden Tanks (12, 14) bzw. aus dem Schichtspeicher-Tank in dem vorgebbaren Mischverhältnis zusammenzuführen.

7. Kühlvorrichtung (10) nach einem der vorstehenden Ansprüche, wobei ein Temperatursensor (S208) vorgesehen ist, um eine Vorlauftemperatur (T_{flow}) des Kühlmittels im Vorlauf (208) zu ermitteln.

8. Kühlvorrichtung (10) nach einem der vorstehenden Ansprüche, wobei ein Temperatursensor (S216) vorgesehen ist, um eine Rücklauftemperatur (Tᵣₑₜᵤᵣₙ) des Kühlmittels im Rücklauf (216) zu ermitteln.

9. Kühlvorrichtung (10) nach einem der vorstehenden Ansprüche, wobei das Betriebsmittel ein Umrichter (22) ist.

10. Kühlvorrichtung (10) nach einem der vorstehenden Ansprüche, wobei der Wärmesenke ein Ventilator 24 mit bevorzugt veränderbarer Drehzahl zugeordnet ist.

11. Kühlvorrichtung (10) nach einem der vorstehenden Ansprüche, wobei die Kühlvorrichtung (10) eine Pumpe mit bevorzugt veränderbarer Drehzahl aufweist.

12. Verfahren zum Kühlen eines Betriebsmittels mit Hilfe eines Kühlmittels und einer Kühlvorrichtung (10),
- wobei die Kühlvorrichtung (10) eine Wärmequelle zur Aufnahme von thermischer Energie aus dem Betriebsmittel in das Kühlmittel und eine Wärmesenke zur Abgabe von thermischer Energie aus dem Kühlmittel umfasst,
- wobei die Wärmequelle und die Wärmesenke miteinander verbunden sind,
- und wobei der Wärmequelle über einen Vorlauf (208) das Kühlmittel zugeführt und aus der Wärmesenke über einen Rücklauf (216) das Kühlmittel abgeführt wird,
**dadurch gekennzeichnet,**
- **dass** die Kühlvorrichtung (10) zwei Tanks (12, 14) bzw. einen Schichtspeicher-Tank für Kühlmittel und eine Schalteinrichtung (30) aufweist,
- **dass** die Schalteinrichtung (30) an die beiden Tanks (12, 14) bzw. den Schichtspeicher-Tank, den Vorlauf (208) und den Rücklauf (216) angeschlossen ist,
- und **dass** dem Vorlauf (208) in einer Betriebsart "Mischkühlung" das Kühlmittel aus den beiden Tanks (12, 14) bzw. aus dem Schichtspeicher-Tank mittels der Schalteinrichtung (30) in einem vorgebbaren Mischverhältnis zugeführt wird.

13. Verfahren nach dem Anspruch 12, wobei in der Betriebsart "Mischkühlung" das Kühlmittel aus dem Rücklauf (216) durch die Schalteinrichtung (30) in einen der beiden Tanks (14) bzw. in den Schichtspeicher-Tank abgeführt wird.

14. Verfahren nach Anspruch 12 oder 13, wobei in einer Betriebsart "Regeneration" das Kühlmittel aus dem einen der beiden Tanks (14) bzw. aus dem Schichtspeicher-Tank mittels der Schalteinrichtung (30) dem Vorlauf (208) zugeführt wird.

15. Verfahren nach dem Anspruch 14, wobei in der Betriebsart "Regeneration" das Kühlmittel aus dem Rücklauf (216) mittels der Schalteinrichtung (30) dem anderen Tank (12) bzw. dem Schichtspeicher-Tank zugeführt wird.

16. Verfahren nach einem der Ansprüche 12 bis 15, wobei in einer Betriebsart "Kreislaufkühlung" der Rücklauf (216) mittels der Schalteinrichtung (30) mit dem Vorlauf (208) verbunden wird.

17. Verfahren nach einem der Ansprüche 12 bis 16, wobei zur Ermittlung des Mischverhältnisses eine gemessene Vorlauftemperatur (T_{flow}) des Kühlmittels mit einem Sollwert (T_{flow}, _{SP1}; T_{flow}, _{SP2}) verglichen wird.

18. Verfahren nach dem vorstehenden Anspruch, wobei auf Basis des Vergleichs ein Signal (C32) gebildet wird, um ein Proportionalventil (32) der Schalteinrichtung (30) entsprechend dem gewünschten Mischverhältnis zu stellen oder zu regeln.
